(19) **Europäisches Patentamt**
**European Patent Office**
**Office européen des brevets**

(11) **EP 4 254 266 A1**

(12) **EUROPEAN PATENT APPLICATION**

(43) Date of publication:
**04.10.2023 Bulletin 2023/40**

(21) Application number: **22164893.4**

(22) Date of filing: **29.03.2022**

(51) International Patent Classification (IPC):
*G06N 3/04* (2023.01)      *G06N 3/08* (2023.01)
*G03F 7/20* (2006.01)

(52) Cooperative Patent Classification (CPC):
**G06N 3/084; G03F 7/705; G03F 7/70616; G06N 3/045;** G06N 3/048

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **ONOSE, Alexandru**
**5500 AH Veldhoven (NL)**

• **VERHEUL, Nick**
**5500 AH Veldhoven (NL)**
• **TIEMERSMA, Bart, Jacobus, Martinus**
**5500 AH Veldhoven (NL)**
• **CERFONTAINE, Pascal**
**5500 AH Veldhoven (NL)**
• **BARBIERI, Davide**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHODS RELATED TO AN AUTOENCODER MODEL OR SIMILAR FOR MANUFACTURING PROCESS PARAMETER ESTIMATION**

(57)      A method for ordering and/or selection of latent elements for modeling low dimensional data within a latent space representation, the low dimensional data being a reduced dimensionality representation of input data as determined by a first model component of a model, comprising the steps of training said model and selecting one of said latent element selections based on said training, said training comprising: reducing a dimensionality of the input data to generate said low dimensional data in said latent space representation; training a second model component of said model for each of one or more latent element selections; and optimizing an approximation of the input data as output by said second model component for each said latent element selection, thereby ranking at least one of said plurality of latent elements in the latent space representation based on a contribution of each latent element to the input data.

Fig. 9

**Description**

TECHNICAL FIELD

This description relates to methods and systems for estimating manufacturing process parameters with a modular autoencoder (or similar) model.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance.

To overcome these difficulties, sophisticated fine-tuning steps may be applied to the lithographic projection apparatus and/or design layout. These include, for example, but are not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Autoencoders can be configured for use in metrology and/or other solutions for parameter inference and/or for other purposes. This deep learning model architecture is generic and scalable to an arbitrary size and complexity. Autoencoders are configured to compress a high dimensional signal (e.g. pupil images in a semiconductor manufacturing process) to an efficient low dimensional representation of the same signal. Next or in parallel (parameter inference may be part of the autoencoder training), parameter inference (i.e. regression) is performed from the low-dimensional representation towards a set of known labels. By first compressing the signal, the inference problem is significantly simplified compared to performing regression on the high dimensional signal directly.

However, it is often difficult to understand the flow of information inside a typical autoencoder. One can reason about the information at the input, at the level of the compressed low dimensional representation, and at the output. One cannot readily interpret the information between these points.

The present modular autoencoder model is less rigid compared to traditional monolithic autoencoder models. The present modular autoencoder model has a greater number of trainable and/or otherwise adjustable components. The modularity of the present model makes it easier to interpret, define, and extend. The complexity of the present model is easily adjusted, and is high enough to model a process that generates the data provided to the model, but low enough to avoid modelling noise or other unwanted characteristics (e.g., the present model is configured to avoid overfitting provided data). As the process (or at least aspects of the process) generating the data is often unknown, choosing an appropriate network complexity usually involves some intuition and trial-and-error. For this reason, it is highly desirable to provide a model architecture that is modular, easy to comprehend, and easy to scale in complexity up and down.

Note that the term autoencoder used in association with the present modular autoencoder model may generally refer to one or more autoencoders configured for partial supervised learning using a latent space for parameter estimation, and/or other autoencoders. This may also include a single autoencoder, which is trained using semi-supervised learning, for example.

SUMMARY OF THE INVENTION

The invention discloses a method for ordering and/or selection of latent elements for modeling low dimensional data within a latent space representation, said low dimensional data being a reduced dimensionality representation of input data as determined by a first model component of a model; the method comprising the steps of: obtaining said input data; training said model, said training comprising reducing a dimensionality of the input data to generate said low dimensional data in said latent space representation, said latent space representation comprising a plurality of latent elements; respectively training a second model component of said model for each of one or more latent element selections, each of said latent element selections comprising one or more of said plurality of latent elements; and optimizing an approximation of the input data as output by said second model component for each said latent element selection, thereby ranking at least one of said plurality of latent elements in the latent space representation based on a contribution of each latent element to the input data; and selecting one of said latent element selections based on said training.

In other aspects of the invention, there is provided a computer program comprising program instructions operable to perform the method of the first or second aspect when run on a suitable apparatus, and a lithographic apparatus which is configured to provide product structures to a substrate in a lithographic process, said lithographic apparatus comprising a processor and the aforementioned computer program

BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:

Figure 1 depicts a schematic overview of a lithographic apparatus, according to an embodiment.

Figure 2 depicts a schematic overview of a lithographic cell, according to an embodiment.

Figure 3 depicts a schematic representation of holistic lithography, representing a cooperation between three technologies to optimize semiconductor manufacturing, according to an embodiment.

Figure 4 illustrates an example metrology apparatus, such as a scatterometer, according to an embodiment.

Figure 5 illustrates first encoder-decoder architecture, adaptable according to an embodiment.

Figure 6 illustrates second encoder-decoder architecture, adaptable according to an embodiment.

Figure 7 illustrates an embodiment of a modular autoencoder model, adaptable according to an embodiment.

Figure 8 illustrates a schematic view of an interconnection structure for generating labels, in order to impose priors onto the modular autoencoder model, according to an embodiment.

Figure 9 illustrates encoder-decoder architecture according to an embodiment.

Figure 10 is a block diagram of an example computer system, according to an embodiment.

DETAILED DESCRIPTION

As described above, autoencoders can be configured for use in metrology and/or other solutions for parameter inference and/or for other purposes. This deep learning model architecture is generic and scalable to an arbitrary size and complexity. Autoencoders are configured to compress a high dimensional signal (e.g. pupil images in a semiconductor metrology platform) to an efficient low dimensional representation of the same signal. Next, parameter inference (i.e. regression) is performed from the low-dimensional representation towards a set of known labels. By first compressing the signal, the inference problem is significantly simplified compared to performing regression on the high dimensional signal directly.

However, it is often difficult to understand the flow of information inside a typical autoencoder. One can reason about the information at the input, at the level of the compressed low dimensional representation, and at the output. One cannot readily interpret the information between these points.

Data driven inference approaches have also been proposed for semiconductor metrology operations and used for the task of parameter estimation. They rely on a significant amount of gathered measurements and models that map measured features to parameters of interest, with labels for these parameters obtained via carefully designed targets on a wafer or from third party measurements. Current approaches have the capability to measure a significant number of channels (multiple wavelengths, observations under multiple wafer rotations, four light polarization schemes, etc.). However, due to practical timing constraints, the number of channels needs to be limited to a subset of those available ones for production measurements. For the selection of the best channels, a brute force approach is often used that tests all possible channel combinations. This is time consuming, resulting in long measurement and/or process recipe creation times. Additionally, a brute force approach can be prone to overfitting, introducing a different bias per channel, and/or other disadvantages.

In semiconductor manufacturing, optical metrology may be used to measure critical stack parameters directly on product (e.g., patterned wafer) structures. Machine-learning methods are often applied on top of optical scatterometry data acquired using a metrology platform. These machine-learning methods conceptually amount to supervised learning approaches, i.e. learning from labeled datasets. The success of such methods is strongly dependent on the quality of the labels. Often, labeled datasets are created by measuring and labelling known targets in a wafer. One of the primary challenges of using targets in this way is the fact that they only provide very accurate relative labels. This means that within one cluster of targets, there is some unknown cluster bias, on top of which accurate labels are known. Determining this unknown cluster bias, and hence obtaining absolute labels, is important to the accuracy of target-based recipes. The procedure of estimating the cluster bias is usually referred to as offset inference.

The present modular autoencoder model is less rigid compared to traditional monolithic autoencoder models. The present modular autoencoder model has a greater number of trainable and/or otherwise adjustable components. The modularity of the present model makes it easier to interpret, define, and extend. The complexity of the present model is high enough to model a process that generates the data provided to the model, but low enough to avoid modelling noise or other unwanted characteristics (e.g., the present model is configured to avoid overfitting provided data). As the process (or at least aspects of the process) generating the data is often unknown, choosing an appropriate network complexity usually involves some intuition and trial-and-error. For this reason, it is highly desirable to provide a model architecture that is modular, easy to comprehend, and easy to scale in complexity up and down.

In addition, the present modular autoencoder model is configured for estimating parameters of interest from a combination of available channels of measurement data from an optical metrology platform by estimating retrievable quantities of information content using a subset of a plurality of input models based on the available channels. The present model is configured to be trained by randomly or otherwise iteratively varying (e.g., sub-selecting) a number of channels that are used to approximate inputs during iterative training steps. This iterative variation / sub-selection ensures that the model remains predictive/consistent for any combination of input channels. Furthermore, since the information content present in the inputs represents all channels (e.g., because each channel was part of the subset of selected channels for at least one training iteration), the resulting model will not include a bias specific to one particular channel.

The present modular autoencoder model is also configured such that known properties of inputs (e.g., domain knowledge) can be embedded into the model during the training phase, which reduces or eliminates (e.g., cluster) bias in subsequent inferences made by the model. In other words, the present modular autoencoder is configured such that known (e.g., symmetry) properties of inputs are embedded into the decoding part of the model, and these embedded known properties allow the model to make bias free inferences.

Note that the term autoencoder used in association with the present modular autoencoder model may generally refer to one or more autoencoders, or one or more parts of an autoencoder, configured for partial supervised learning using a latent space for parameter estimation, and/or other operations. In addition, the various drawbacks (e.g., of prior systems) and advantages (of the present modular autoencoder model) described above are examples of many other possible drawbacks and advantages, and should not be considered limiting.

Finally, although specific reference may be made in this text to the manufacture of integrated circuits, the description herein has many other possible applications. For example, it may be employed in the manufacture of integrated optical systems, guidance and detection patterns for magnetic domain memories, liquid-crystal display panels, thin-film magnetic heads, etc. In these alternative applications, the skilled artisan will appreciate that, in the context of such alternative applications, any use of the terms "reticle", "wafer" or "die" in this text should be considered as interchangeable with the more general terms "mask", "substrate" and "target portion", respectively. In addition, it should be noted that the method described herein may have many other possible applications in diverse fields such as language processing systems, self-driving cars, medical imaging and diagnosis, semantic segmentation, denoising, chip design, electronic design automation, etc. The present method may be applied in any fields where quantifying uncertainty in machine learning model predictions is advantageous.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

A patterning device may comprise, or may form, one or more design layouts. The design layout may be generated utilizing CAD (computer-aided design) programs. This process is often referred to as EDA (electronic design automation). Most CAD programs follow a set of predetermined design rules in order to create functional design layouts/patterning devices. These rules are set based processing and design limitations. For example, design rules define the space tolerance between devices (such as gates, capacitors, etc.) or interconnect lines, to ensure that the devices or lines do not interact with one another in an undesirable way. One or more of the design rule limitations may be referred to as a "critical dimension" (CD). A critical dimension of a device can be defined as the smallest width of a line or hole, or the smallest space between two lines or two holes. Thus, the CD regulates the overall size and density of the designed device. One of the goals in device fabrication is to faithfully reproduce the original design intent on the substrate (via the patterning device).

The term "reticle," "mask," or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective; binary, phase-shifting, hybrid, etc.), examples of other such patterning devices include a programmable mirror array.

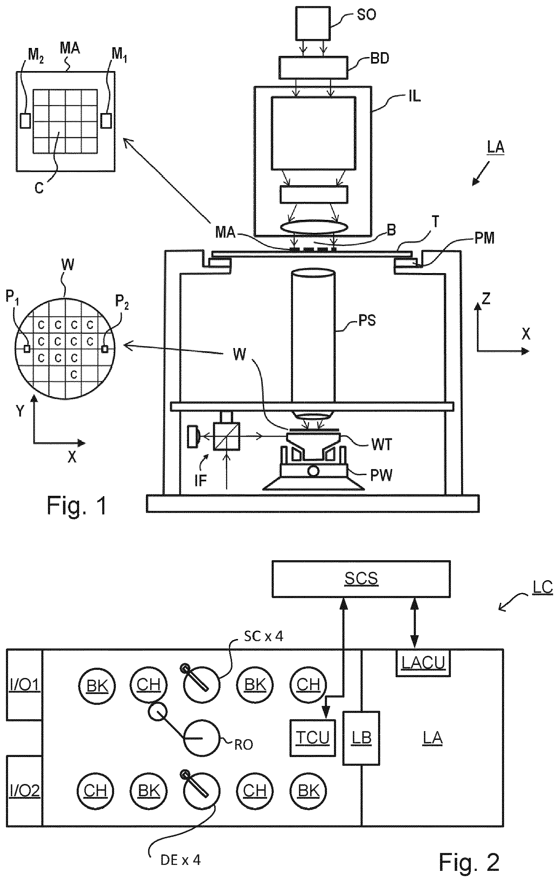

As a brief introduction, Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT configured to hold a substrate (e.g., a resist coated wafer) W and coupled to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

Figure 2 depicts a schematic overview of a lithographic cell LC. As shown in Figure 2 the lithographic apparatus LA may form part of lithographic cell LC, also sometimes referred to as a lithocell or (litho)cluster, which often also includes apparatus to perform pre- and post-exposure processes on a substrate W. Conventionally, these include spin coaters SC configured to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W (Figure 1) exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W (Figure 1), and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

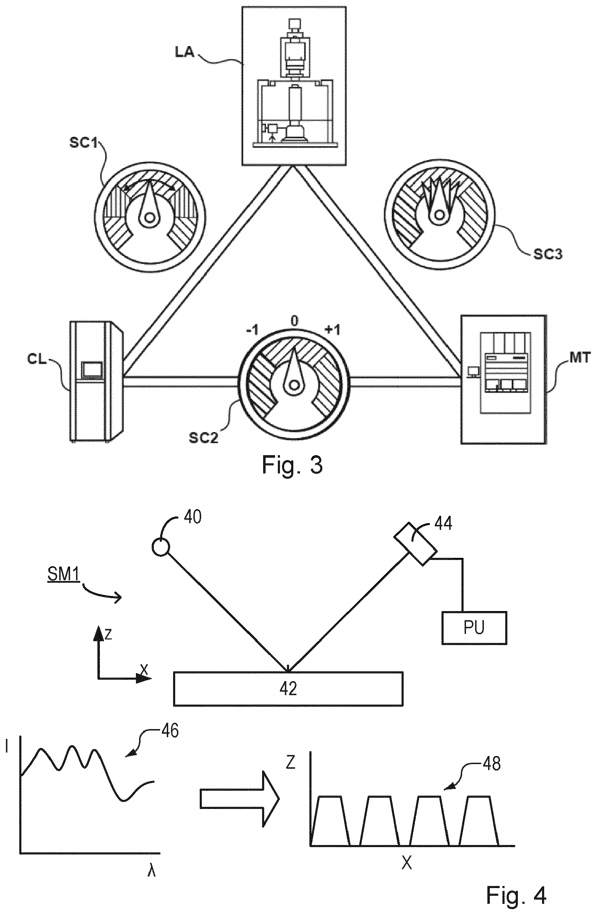

Figure 3 depicts a schematic representation of holistic lithography, representing a cooperation between three technologies to optimize semiconductor manufacturing. Typically, the patterning process in a lithographic apparatus LA is one of the most critical steps in the processing which requires high accuracy of dimensioning and placement of structures on the substrate W (Figure 1). To ensure this high accuracy, three systems (in this example) may be combined in a so called "holistic" control environment as schematically depicted in Figure. 3. One of these systems is the lithographic apparatus LA which is (virtually) connected to a metrology apparatus (e.g., a metrology tool) MT (a second system), and to a computer system CL (a third system). A "holistic" environment may be configured to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology apparatus (tool) MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequent measurements of the structures created, e.g., for process control and verification. Tools to make such measurements include metrology tool (apparatus) MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure features of a substrate such as gratings using light from soft x-ray and visible to near-IR wavelength range, for example.

In some embodiments, a scatterometer MT is an angular resolved scatterometer. In these embodiments, scatterometer reconstruction methods may be applied to the measured signal to reconstruct or calculate properties of a grating and/or other features in a substrate. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In some embodiments, scatterometer MT is a spectroscopic scatterometer MT. In these embodiments, spectroscopic scatterometer MT may be configured such that the radiation emitted by a radiation source is directed onto target features of a substrate and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In some embodiments, scatterometer MT is a ellipsometric scatterometer. The ellipsometric scatterometer allows for determining parameters of a lithographic process by measuring scattered radiation for each polarization states. Such a metrology apparatus (MT) emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In some embodiments, scatterometer MT is adapted to measure the overlay of two misaligned gratings or periodic structures (and/or other target features of a substrate) by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in patent application EP1,628,164A, such that any asymmetry is clearly distinguishable. This provides a way to measure misalignment in gratings. Further examples for measuring overlay may be found in PCT patent application publication no. WO 2011/012624 or US patent application US 20160161863, incorporated herein by reference in their entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure (e.g., feature in a substrate) may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings and/or other features in a substrate, formed by a lithographic process, commonly in resist, but also after etch processes, for example. In some embodiments, one or more groups of targets may be clustered in different locations around a wafer. Typically the pitch and line-width of the structures in the gratings depend on the measurement optics (in particular the NA of the optics) to be able to capture diffraction orders coming from the metrology targets. A diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

Figure 4 illustrates an example metrology apparatus (tool or platform) MT, such as a scatterometer. MT comprises a broadband (white light) radiation projector 40 which projects radiation onto a substrate 42. The reflected or scattered radiation is passed to a spectrometer detector 44, which measures a spectrum 46 (i.e. a measurement of intensity as a function of wavelength) of the specular reflected radiation. From this data, the structure or profile giving rise to the detected spectrum may be reconstructed 48 by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer, for example.

It is often desirable to be able computationally determine how a patterning process would produce a desired pattern on a substrate. Computational determination may comprise simulation and/or modeling, for example. Models and/or simulations may be provided for one or more parts of the manufacturing process. For example, it is desirable to be able to simulate the lithography process of transferring the patterning device pattern onto a resist layer of a substrate as well as the yielded pattern in that resist layer after development of the resist, simulate metrology operations such as the determination of overlay, and/or perform other simulations. The objective of a simulation may be to accurately predict, for example, metrology metrics (e.g., overlay, a critical dimension, a reconstruction of a three dimensional profile of features of a substrate, a dose or focus of a lithography apparatus at a moment when the features of the substrate were printed with the lithography apparatus, etc.), manufacturing process parameters (e.g., edge placements, aerial image intensity slopes, sub resolution assist features (SRAF), etc.), and/or other information which can then be used to determine whether an intended or target design has been achieved. The intended design is generally defined as a pre-optical proximity correction design layout which can be provided in a standardized digital file format such as GDSII, OASIS or another file format.

Simulation and/or modeling can be used to determine one or more metrology metrics (e.g., performing overlay and/or other metrology measurements), configure one or more features of the patterning device pattern (e.g., performing optical proximity correction), configure one or more features of the illumination (e.g., changing one or more characteristics of a spatial / angular intensity distribution of the illumination, such as change a shape), configure one or more features of the projection optics (e.g., numerical aperture, etc.), and/or for other purposes. Such determination and/or configuration can be generally referred to as mask optimization, source optimization, and/or projection optimization, for example. Such optimizations can be performed on their own, or combined in different combinations. One such example is source-mask optimization (SMO), which involves the configuring of one or more features of the patterning device pattern together with one or more features of the illumination. The optimizations may use the parameterized model described herein to predict values of various parameters (including images, etc.), for example.

In some embodiments, an optimization process of a system may be represented as a cost function. The optimization process may comprise finding a set of parameters (design variables, process variables, inspection operation variables, etc.) of the system that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function can also be the maximum of these deviations (i.e., worst deviation). The term "evaluation points" should be interpreted broadly to include any characteristics of the system or fabrication method. The design and/or process variables of the system can be confined to finite ranges and/or be interdependent due to practicalities of implementations of the system and/or method. In the case of a lithographic projection and/or an inspection apparatus, the constraints are often associated with physical properties and characteristics of the hardware such as tunable ranges, and/or patterning device manufacturability design rules. The evaluation points can include physical points on a resist image on a substrate, as well as non-physical characteristics such as dose and focus, for example.

In some embodiments, the present system(s) and method(s) may include an empirical model that performs one or more of the operations described herein. The empirical model may predict outputs based on correlations between various inputs (e.g., one or more characteristics of a pupil image, one or more characteristics of a complex electric field image, one or more characteristics of a design layout, one or more characteristics of the patterning device, one or more characteristics of the illumination used in the lithographic process such as the wavelength, etc.).

As an example, the empirical model may be a parameterized model and/or other models. The parameterized model may be a machine learning model and/or any other parameterized model. In some embodiments, a machine learning model (for example) may be and/or include mathematical equations, algorithms, plots, charts, networks (e.g., neural networks), and/or other tools and machine learning model components. For example, a machine learning model may be and/or include one or more neural networks (e.g., neural network blocks) having an input layer, an output layer, and one or more intermediate or hidden layers. In some embodiments, the one or more neural networks may be and/or include deep neural networks (e.g., neural networks that have one or more intermediate or hidden layers between the input and output layers).

As an example, the one or more neural networks may be based on a large collection of neural units (or artificial neurons). The one or more neural networks may loosely mimic the manner in which a biological brain works (e.g., via large clusters of biological neurons connected by axons). Each neural unit of a neural network may be connected with many other neural units of the neural network. Such connections can be enforcing or inhibitory in their effect on the activation state of connected neural units. In some embodiments, each individual neural unit may have a summation function that combines the values of all its inputs together. In some embodiments, each connection (or the neural unit itself) may have a threshold function such that a signal must surpass the threshold before it is allowed to propagate to other neural units. These neural network systems may be self-learning and trained, rather than explicitly programmed, and can perform significantly better in certain areas of problem solving, as compared to traditional computer programs. In some embodiments, the one or more neural networks may include multiple layers (e.g., where a signal path traverses from front layers to back layers). In some embodiments, back propagation techniques may be utilized by the neural networks, where forward stimulation is used to reset weights on the "front" neural units. In some embodiments, stimulation and inhibition for the one or more neural networks may be freer flowing, with connections interacting in a more chaotic and complex fashion. In some embodiments, the intermediate layers of the one or more neural networks include one or more convolutional layers, one or more recurrent layers, and/or other layers.

The one or more neural networks may be trained (i.e., whose parameters are determined) using a set of training data (e.g., ground truths). The training data may include a set of training samples. Each sample may be a pair comprising an input object (typically an image, a measurement, a tensor or vector which may be called a feature tensor or vector) and a desired output value (also called the supervisory signal). A training algorithm analyzes the training data and adjusts the behavior of the neural network by adjusting the parameters (e.g., weights of one or more layers) of the neural network based on the training data. For example, given a set of N training samples of the form $\{(x_1,y_1), (x_2,y_2), \dots , (x_N,y_N)\}$ such that $x_i$ is the feature tensor / vector of the i-th example and $y_i$ is its supervisory signal, a training algorithm seeks a neural network g: X → Y, where X is the input space and Y is the output space. A feature tensor / vector is an n-dimensional tensor / vector of numerical features that represent some object (e.g., a complex electric field image). The tensor / vector space associated with these vectors is often called the feature or latent space. After training, the neural network may be used for making predictions using new samples.

As described herein, the present modular autoencoder model includes one or more parameterized models (e.g., machine learning models such as a neural network) that use an encoder-decoder architecture, and/or other models. In the middle (e.g., middle layers) of the model (e.g., a neural network), the present model formulates a low-dimensional encoding (e.g., in a latent space) that encapsulates information in an input (e.g., a pupil image and/or other input associated with a pattern or other features of a semiconductor manufacturing and/or metrology (and/or other sensing) process) to the model. The present modular autoencoder model leverages the low dimensionality and compactness of the latent space to make parameter estimations and/or predictions.

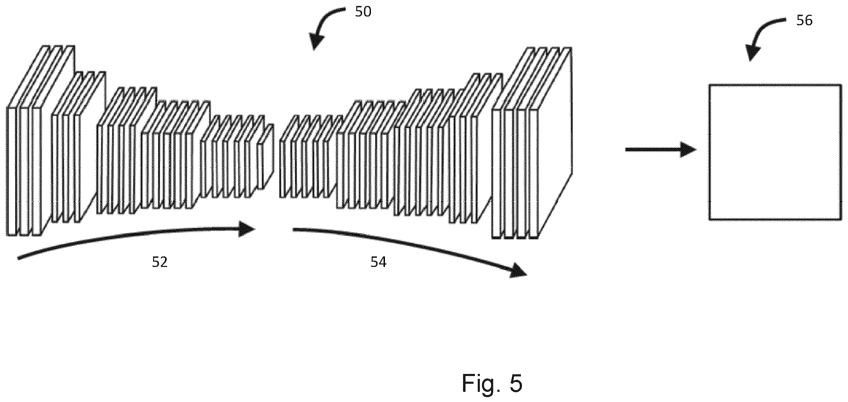

By way of a non-limiting example, Figure 5 illustrates general encoder-decoder architecture 50. Encoder-decoder architecture 50 has an encoding portion 52 (an encoder) and a decoding portion 54 (a decoder). In the example shown in Figure 5, encoder-decoder architecture 50 may output predicted pupil images 56 and/or other outputs, for example.

In some embodiments, the low dimensional encoding z represents one or more features of an input (e.g., a pupil image). The one or more features of the input may be considered key or critical features of the input. Features may be considered key or critical features of an input because they are relatively more predictive than other features of a desired output and/or have other characteristics, for example. The one or more features (dimensions) represented in the low dimensional encoding may be predetermined (e.g., by a programmer at the creation of the present modular autoencoder model), determined by prior layers of a neural network, adjusted by a user via a user interface associated with a system described herein, and/or may be determined in by other methods. In some embodiments, a quantity of features (dimensions) represented by the low dimensional encoding may be predetermined (e.g., by the programmer at the creation of the present modular autoencoder model), determined based on output from prior layers of the neural network, adjusted by the user via the user interface associated with a system described herein, and/or determined by other methods.

It should be noted that even though a machine learning model, a neural network, and/or encoder-decoder architecture are mentioned throughout this specification, a machine learning model, a neural network, and encoder-decoder architecture are just examples, and the operations described herein may be applied to different parameterized models.

As described above, process information (e.g., images, measurements, process parameters, metrology metrics, etc.) may be used to guide various manufacturing operations. Utilizing the relatively lower dimensionality of a latent space to predict and/or otherwise determine the process information may be faster, more efficient, require fewer computing resources, and/or have other advantages over prior methods for determining process information.

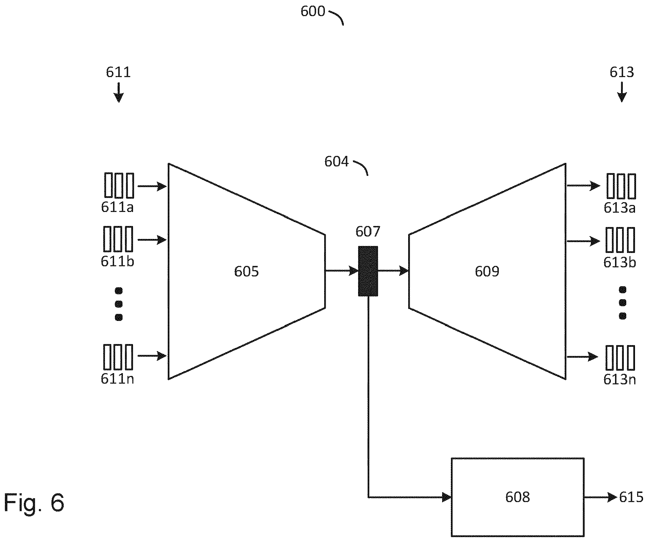

Figure 6 illustrates an embodiment of an autoencoder model arrangement 600 to which the concepts disclosed herein may be applied. In general, autoencoder models can be adapted for use in metrology and/or other solutions for parameter inference and/or for other purposes. Inference may comprise estimating parameters of interest from data and/or other operations. For example, this may comprise finding a latent representation in a forward way by evaluating an encoder, or in an inverse way, by solving the inverse problem using a decoder (as described herein). After finding the latent representation, parameters of interest may be found by evaluating a prediction/estimation model (also as described herein). Additionally, the latent representation provides a set of outputs (because one can evaluate a decoder, given a latent representation), which can be compared to the data, for example. In essence, within the present context, inference and estimation (of parameters of interest) can be used interchangeably. Autoencoder model architecture is generic and scalable to an arbitrary size and complexity. Autoencoder models are configured to compress a high-dimensional signal (input) to an efficient low-dimensional representation of the same signal. Parameter inference (e.g., which can include regression and/or other operations) is performed from the low-dimensional representation, one or more outputs, and/or other information, towards a set of known labels. Labels may be the "references" used in supervised learning. Within this context, this may mean either external references one would like to reproduce, or a design of carefully crafted metrology targets. Measuring carefully crafted metrology target may include measuring known targets that have known (absolute/relative) properties (e.g. overlay and/or other properties, for example). By first compressing the (input) signal, the inference problem is significantly simplified compared to performing regression and/or other operations on the high dimensional signal directly.

The autoencoder model 604 of Figure 6, may be used to compress the input information 611 (e.g., 611a, 611b, ..., 611n) to a bottleneck (e.g., the point of compression or latent space 607 in model 600), and expand the information again to a level suitable for splitting into multiple outputs. Prediction model 608 may be used to estimate parameters of interest from the information passing through the latent space.

In some embodiments, autoencoder model 604 is configured to determine, in latent space 607 (where there are fewer degrees of freedom to analyze compared to the number of degrees of freedom for the raw input data from different sensors and/or tools), a latent space representation of a given input 611. Process information may be estimated and/or predicted, and/or other operation may be performed, based on the latent space representation of the given input 611.

In some embodiments, autoencoder model 604 comprises an encoder portion 605, a latent space 607, a decoder portion 609, and/or other components. In some embodiments, the autoencoder model comprises feed forward and/or residual layers, and/or other components, though these example structures should not be considered limiting. Encoder portion 605 of autoencoder model 604 may be configured to combine the inputs 611 and reduce a dimensionality of the combined processed inputs to generate low dimensional data in latent space 607.

Autoencoder model 604 may be configured to expand the low dimensional data in the latent space into one or more expanded versions of the one or more inputs 611. Expanding the low dimensional data in latent space 607 into the one or more expanded versions of the one or more inputs 611 may comprise decoding, generating a decoder signal, and/or other operations, for example. In general, the one or more expanded versions of the one or more inputs may comprise the output from (e.g., a last layer of) autoencoder model 604. However, the one or more expanded versions of the one or more inputs 611 may include any expanded version from any layer of decoder portion 609. The one or more expanded versions of the one or more inputs 611 may have increased dimensionality compared to the low dimensional data in latent space 607. The one or more expanded versions of the one or more inputs 611 may be configured to be suitable for generating one or more different outputs 613 (e.g., 613a, 613b, ...613n). Note that the inputs to autoencoder model 604 are not necessarily recovered as its outputs. This is intended to simply describe an interface. However, recovery may hold globally, input 611 to output 613.

Prediction model 608 may be configured to estimate one or more parameters (parameters of interest) 615 based on the low dimensional data in latent space 607, the one or more different outputs 613, and/or other information. In some embodiments, for example, the one or more parameters may be semiconductor manufacturing process parameters (as described herein). In some embodiments, prediction model 608 comprises feed forward, residual layers, and/or other components, though these example structures are not intended to be limiting. By way of a non-limiting example, an input 611 sensor signal may comprise a pupil image, and an encoded representation of the pupil image may be configured to be used by prediction model 608 to estimate overlay and/or other parameters.

By way of a non-limiting example, an input 611 may comprise a sensor signal (e.g., a measurement pupil or a processed representation thereof) associated with a sensing or metrology operation in a semiconductor manufacturing process, a low dimensional representation of the input 611 may be a compressed representation of the sensor signal, and the corresponding output 613 may be an approximation of the input sensor signal.

In some embodiments, inputs 611 are associated with a pupil, a target, and/or other components of a semiconductor manufacturing process, and received from one or more of a plurality of characterization apparatuses configured to generate input 611. The characterization apparatuses may include various sensors and/or tools configured to generate data about a target. In some embodiments, a characterization apparatus may include an optical metrology platform such as the one shown in Figure 4, for example. The data may include images, values for various metrics, and/or other information. In some embodiments, input 611 comprises one or more of an input image, an input process measurement and/or series of process measurements, and/or other information. In some embodiments, an input 611 may be a signal associated with a channel of measurement data from one or more sensing (e.g., optical metrology and/or other sensing) platforms. A channel may be a mode in which one observes a stack, for example, a machine/physical configuration used when taking a measurement. By way of a non-limiting example, an input 611 may comprise an image (e.g., any image associated with or generated during semiconductor manufacturing).

In some embodiments, autoencoder model 600 may be trained by comparing the one or more different outputs 613 to corresponding inputs 611, and adjusting a parameterization of the autoencoder model 604 and/or prediction model 608 to reduce or minimize a difference between an output 613 and a corresponding input 611. In some embodiments, training may include applying variation to the low dimensional data in latent space 607 such that common model 604 decodes a relatively more continuous latent space to generate a decoder signal (e.g., an output from autoencoder model 604); recursively providing the decoder signal to the encoder portion 605 autoencoder model 604) to generate new low dimensional data; comparing the new low dimensional data to the prior low dimensional data; and adjusting (e.g., changing weights, changing constants, changing an architecture, etc.) one or more components (autoencoder model 604 and/or prediction model 608) based on the comparison to reduce or minimize a difference between the new low dimensional data and the prior low dimensional data.

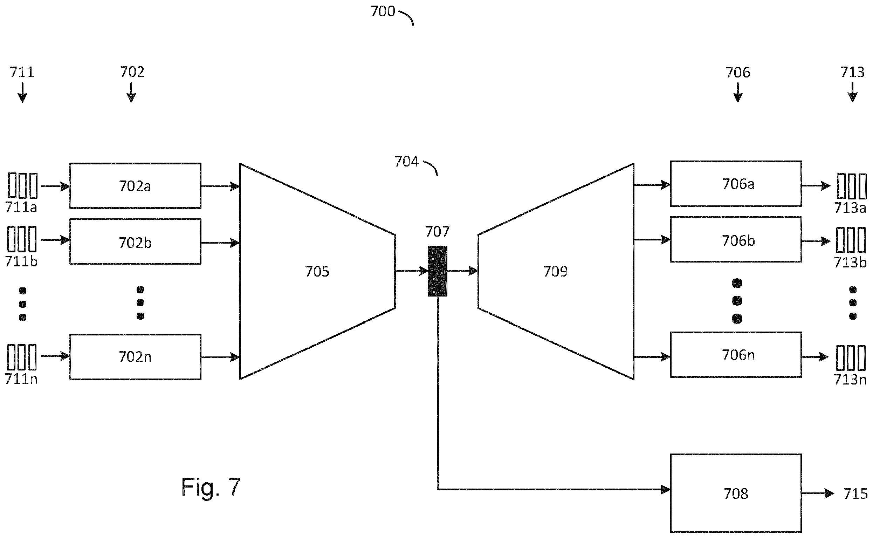

Figure 7 illustrates an embodiment of an autoencoder model 700; where the autoencoder model 700 comprises a modular autoencoder model. The modular autoencoder model 600 may be configured for several different inputs and several different outputs, contrary to typical autoencoder models.

It can be difficult to understand the flow of information inside a typical autoencoder. Its architecture is often opaque and/or non-transparent, and it is typically only possible to reason about information at a model input, at the model output, and at the point of compression (i.e., in the latent space). Information is not easy to interpret between these points. In practice, there may be auxiliary information (in addition to the input) available, such as physical properties of a target on a wafer and a corresponding sensor in a semiconductor manufacturing process. This auxiliary information can be used as prior knowledge (e.g., "a prior") to ensure the model predictions match a physical reality, to improve the autoencoder model's performance, or to extend the autoencoder model's applicability. However, in a typical autoencoder model having rigid architecture comprising an input, a point of compression, and an output, it is unclear how to incorporate any such information (e.g., it is not clear where or how any such information could be inserted into or used by the model).

This specific example of an autoencoder model 700 has a modular structure. This allows construction of intermediate levels of abstraction that can be used to exploit auxiliary information. The autoencoder model may be embodied as a computer program (e.g., instructions stored on a non-transitory computer readable medium) which cause a computer (e.g., one or more processors) to execute (e.g., train and/or evaluate) model 700 for parameter estimation and/or prediction, for example. In some embodiments, model 700 (and/or any of the individual components of model 700 described below) may be configured *a priori*, before seeing training data. In some embodiments, the estimated and/or predicted parameters comprise one or more of an image (e.g., a pupil image, an electric field image, etc.), a process measurement (e.g., a metric value), and/or other information. In some embodiments, a process measurement comprises one or more of a metrology metric, an intensity, an xyz position, a dimension, an electric field, a wavelength, an illumination and/or detection pupil, a bandwidth, an illumination and/or detection polarization angle, an illumination and/or a detection retardance angle, and/or other process measurements. Modular autoencoder model 700 is configured for partial supervised learning using a latent space for parameter estimation (as further described below).

As shown in Figure 7, a modular autoencoder model 700 is formed with four types of sub-models: input models 702 (e.g., one or more input models 702 (a, b, ..., n)), a common model 704, output models 706 (e.g., one or more output models 706 (a, b, ..., n)), and a prediction model 708 (though any number, type, and/or arrangement of sub-models is possible). Input models 702 are configured for processing input data to a higher level of abstraction, suitable for combination with other inputs. Common model 704 may comprise autoencoder model 604 of Figure 6, and be used to join the inputs (output of input models 702), compress the information to a bottleneck (e.g., the point of compression or latent space in model 700), and expand the information again to a level suitable for splitting into multiple outputs (for output models 706). Output models 706 may process the information from this common abstraction level to multiple outputs that approximate the respective inputs. Prediction model 708 may be used to estimate parameters of interest from the information passing through the latent space. Finally, note that modular autoencoder model 700 may be configured for several different inputs and several different outputs, contrary to typical autoencoder models.

Generally, modular autoencoder model 700 may be more complex (in terms of number of free parameters) than typical monolithic models discussed above. However, in exchange, this more complex model is easier to interpret, define, and extend. The complexity of the network is chosen for any neural network. This complexity should be high enough to model the process that underlies the data, but low enough not to model the noise realization (this is commonly interpreted as a form of overfitting). The model may be configured to model the way a sensor views an outcome of a manufacturing process on a wafer, for example. As the process generating the data is often unknown (or has unknown aspects), choosing an appropriate network complexity usually involves some intuition and trial-and-error. For this reason, it is desirable to provide, by way of modular autoencoder model 700, a model architecture that is easy to comprehend and in which it is clear how to scale the model complexity up and down.

In some embodiments, input models 702 may be provided to perform at least some of the encoding. For example, encoding may include processing the one or more inputs 711 to the first level of dimensionality (e.g., by input models 702), and reducing the dimensionality of the combined processed inputs (e.g., by encoder portion 705). This can include reducing the dimensionality of an input 711 to form the low dimensional data in latent space 707, and/or any amount of dimensional reduction (e.g., by one or more layers of encoder portion 705) before actually reaching the low dimensional level in latent space 707. Note that this dimensionality reduction is not necessarily monotonic. For example, the combination (by means of concatenation) of inputs can be considered an increase in dimensionality.

Here, one or more input models 702, common model 704, one or more output models 706, and/or prediction model 708 may be separate from each other and can be configured to correspond to process physics differences in different parts of a manufacturing process and/or a sensing operation. Model 700 may be configured in this way so that each of the one or more input models 702, common model 704, the one or more output models 706, and/or prediction model 708 can be trained together and/or separately, but individually configured based on the process physics for a corresponding part of the manufacturing process and/or sensing operation, apart from other models in modular autoencoder model 700. By way of a non-limiting example, physically, target and sensor contributions in optical metrology apparatuses (tools, platforms, etc.) are separable. In other words, different targets can be measured with the same sensor. Because of this, it is possible to model the target and sensor contributions separately. Put another way, one or more input models 702, common model 704, one or more output models 706, and/or prediction model 708 may be associated with physics for light as it propagates through a sensor or a stack.

One or more input models 702 are configured to process one or more inputs 711 (e.g., 711a, 711b, ..., 711n) to a first level of dimensionality suitable for combination with other inputs. Processing may include filtering and/or otherwise transforming an input into a model friendly format, compressing the input, projecting data onto a lower dimensional subspace to accelerate the training procedure, data normalization, processing out signal contributions coming from a sensor (e.g. source fluctuation, sensor dose configuration (amount of light produced), etc.) and/or other processing operations. Processing may be thought of as preprocessing, for example, to ensure an input, or data associated with an input, is suitable for model 700, suitable for combination with other inputs, etc. The first level of dimensionality may be the same as or less than a level of dimensionality of a given input 711. In some embodiments, one or more input models 702 comprise dense (e.g., linear layers and/or dense layers with different activation) feed-forward layers, convolutional layers, and/or residual network architecture of modular autoencoder model 700. These structures are examples only, and should not be considered limiting.

In some embodiments, the inputs 711 may comprise images associated with a pupil, a target, and/or other components of a semiconductor manufacturing process, and received from one or more of a plurality of characterization apparatuses configured to generate input 711. Each input image may be pre-processed by an input model 702, and encoded by encoder portion 705 (described below) of common model 704 into low dimensional data that represents the image in a latent space 707 (described below). Note that in some embodiments, input model(s) 702 may be, or be thought of as, part of encoder portion 705. The low dimensional data may then be decoded, used to estimate and/or predict process information, and/or for other purposes.

Common model 704 may comprise encoder-decoder architecture, variational encoder-decoder architecture, and/or other architecture, and may comprise the autoencoder model 604 described above. The low dimensional data in latent space 707 may have a second level of resulting reduced dimensionality that is less than the first level (e.g., the level of dimensionality of the processed input). In other words, the resulting dimensionality after reduction is less than it was before reduction. In some embodiments, the low dimensional data in the latent space may have one or more different forms, such as a tensor, a vector, and/or other latent space representations (e.g., something that has fewer dimensions than the number of dimensions associated with a given input 711).

Prediction model 708 may operate in a similar or same fashion as prediction model 608 already described.

One or more output models 706 may be configured to use the one or more expanded versions of the one or more inputs 711 to generate the one or more different outputs 713. The one or more different outputs 713 may comprise approximations of the one or more inputs 711, the one or more different outputs 713 may have the same or increased dimensionality compared to the expanded versions (e.g., the output from common model 704) of the one or more inputs 711. In some embodiments, the one or more output models 706 may comprise dense feed-forward layers, convolutional layers, and/or residual network architecture of the modular autoencoder model, though these example structures are not intended to be limiting.

In some embodiments, modular autoencoder model 700 may be trained in a monolithic way across all sub-models 702-708 (although it may also be separate for each model). In other words, varying the data in latent space 707 impacts the other components of modular autoencoder model 700. In some embodiments, adjusting comprises adjusting at least one weight, a constant, and/or an architecture (e.g., a number of layers, etc.) associated with a layer of one or more input models 702, common model 704, one or more output models 706, prediction model 708, and/or other components of model 700. These and other aspects of training modular autoencoder model 700 are described in greater detail relative to other figures.

Modular autoencoder model 700 may have an extended range of applicability for estimating parameters of interest for manufacturing and/or sensing (e.g., optical metrology) operations because it may be configured to enforce known properties of inputs 711 in decoder portion 709, which can include one or more output models 706. In some embodiments, decoder portion 709 may be configured to generate an output 713 corresponding to an input 711 by decoding a low dimensional representation of input 711 while enforcing, during decoding (a result of enforcement during training), a known property of the encoded input 711 to generate output 713. Effectively, enforcement occurs originally during training. After training, the enforcement becomes a property of the model, although strictly speaking a decoding is also performed during training. The known property may be associated with a known physical relationship between the low dimensional representation in latent space 707 for input 711, and output 713. In some embodiments, the known property may be a known symmetry property, a known non-symmetry property, and/or other known properties. In some embodiments, decoder portion 709 may be configured to enforce the known property at some intermediate decoding level (e.g., at the interface between common model 704 and output models 706), utilizing the modularity of model 700. A parameter of interest can be estimated based on output 713 and/or the low dimensional representation of input 711 in latent space 707 (as described herein). For example, in some embodiments, for the prediction model, with respect to the use of symmetries, the prediction model may be a selection mask (e.g., selection of the parameters from the latent space to be associated with the parameter of interest). This can still be represented as a neural network layer. However, it may remain fixed during training (e.g., it becomes a fixed linear layer $\sigma$ ($\mathbf{W} \, x$ + $\mathbf{b}$) where each row in $\mathbf{W}$ contains only one value 1 and the other elements are set to 0, $\mathbf{b}$ contains only elements equal to 0 and $\sigma$ (·) is identity).

In some embodiments, decoder portion 709 (which can include one or more output models 706 in some embodiments) may be configured to enforce a known symmetry property and/or other properties of an encoded input during a training phase, such that modular autoencoder model 700 obeys the enforced known symmetry property (and/or other properties) during an inference phase to generate the output. Enforcing comprises penalizing differences between output 713 and an output that should be generated according to the known property using a penalty term in a cost function associated with decoder portion 709 (this can include one or more output models 706). The penalty term may comprise a difference between decoded versions of the low dimensional representation of the input which are related to each other through physical priors. In some embodiments, the known property is a known symmetry property, and the penalty term may comprise a difference between decoded versions of the low dimensional representation of input 711 which are reflected across, or rotated around, a point of symmetry, relative to each other. In some embodiments, one or more of the input models 702, encoder portion 705, decoder portion 709, one or more of the output models 706, prediction model 708, and/or other components of model 700 (see Figure 7) are configured to be adjusted (e.g., trained or further trained) based on any differences between the decoded versions of the low dimensional representation.

By way of a non-limiting example, optical metrology platforms (e.g., apparatuses, tools, etc.) are configured to measure critical semiconductor stack parameters directly on product structures. To do so, machine learning methods are often applied on top of optical scatterometry data acquired using the optical metrology platform. These machine learning methods conceptually amount to supervised learning approaches, i.e. learning from labeled datasets. The success of such methods is dependent on the quality of the labels.

There are common approaches for obtaining labels. One approach uses self-reference targets, which are specifically designed targets for obtaining labeled data. A second approach relies on a tool of record in a semiconductor fab (typically a scanning electron microscope). Due to the competitive advantage of having freedom in design of a self-reference target, and due to the independence of competitive metrology solutions, the self-reference target approach is often preferred.

One of the primary challenges of using self-reference targets is the fact that they only provide very accurate *relative* labels. This means that within one target cluster, there is some unknown cluster bias (target or cluster offset), *on top of which* accurate labels are known. Determining this unknown cluster bias, and hence obtaining absolute labels, is important to the accuracy of self-reference target based manufacturing and/or inspection parameter recipes. The procedure of estimating the cluster bias may be referred to as offset inference or label correction.

For a linear signal (e.g., input 711 such as pupil images, etc.) as a function of the parameter of interest, this offset inference problem is unsolvable. Hence, approaches to exploit non-linearity in the signal, (e.g., the pupil images and/or other inputs 711), are being explored. At present, there is no approach known to us that exploits physical assumptions regarding signal non-linearity, and/or direction in the signal-space.

A signal (e.g., input 711) of interest (e.g., from a metrology platform), such as an anti-symmetric cross-polarized pupil signal caused by overlay, is anti-symmetric (an odd-symmetric function) with regards to the stack parametrization, when all asymmetric parameters are negated simultaneously. More specifically, the signal may be anti-symmetric (an odd-symmetric function) around 0 overlay when all other asymmetric parameters are zero. This kind of domain knowledge can be embedded into model 700 during the training phase, which adds physical interpretability to model 700. Moreover, the point of symmetry is of significance, as it defines the origin (the zero) of the model's parameterization, which can be exploited to calibrate absolute accuracy such that the appropriate corrected labels can be found. Model 700 is configured to exploit this and other physical understandings and embed it into model 700. In this example, the general pupil property that is exploited is the following:

$$I_{DE}^a(c_a) = -I_{DE}^a(-c_a)$$

where $I^a{}_{DE}$ represents antisymmetric normalized pupils and $c_a$ is the collection of asymmetric parameters.

Input 711 $P$ in this example, can be a pupil image ( $P = I_{DE}^a$ for notational convenience), ($P$) may encode (e.g., by one or more input models 702 and/or common model 704) this pupil image into a compressed representation $\{\hat{c}_s, \hat{c}_a\}$, which is finally decoded by $g(\hat{c}_s, \hat{c}_a)$ to produce an approximate pupil $\hat{P} \approx P$. This model is trained in such a way that $\widehat{ov} \subset \hat{c}_a$ approximates true overlay $ov$, i.e. one of the elements in $\hat{c}_a$ represents overlay. For self-reference targets this model can be trained using the following objective (e.g., cost function):

$$\underset{f,g,B}{\mathrm{argmin}} \left\|\left| P - \hat{P} \right|\right|^2 + \alpha \left|\left| ov - \widehat{ov} \right|\right|^2$$

where the true overlay is set to $ov = L+B$, with known labels $L$ and unknown cluster biases $B$. In practice, this approach may be insufficient as there is some freedom to choose the cluster biases $B$. This effectively amounts to moving the origin of the parameterization $\{\hat{c}_s, \hat{c}_a\}$, which may be problematic, because absolute overlay estimation is desired. In order to reduce this ambiguity, another term may be added to the objective (cost function) that embeds the symmetry properties of the signal (e.g., input 711) into the decoding model $g(\hat{c}_s, \hat{c}_a)$ (e.g., common model 704 and/or one or more output models 706):

$$\underset{f,g,B}{\mathrm{argmin}} \left\|\left| P - \hat{P} \right|\right|^2 + \alpha \left|\left| ov - \widehat{ov} \right|\right|^2 + \beta \left|\left| g(\hat{c}_s, \hat{c}_a) + g(\hat{c}_s, -\hat{c}_a) \right|\right|^2$$

for any $\{\hat{c}_s, \hat{c}_a\}$. In practice, minimization of this cost function for any $\{\hat{c}_s, \hat{c}_a\}$ cannot be ensured, however, points from the process window can be sampled to ensure that the third terms is small for an arbitrarily large sample.

The principles described herein (e.g., utilizing the relatively lower dimensionality of a latent space in a trained parameterized model to predict and/or otherwise determine process information) may have multiple additional applications (e.g., in addition to and/or instead of the applications described above). For example, the present system(s) and method(s) may be used to harmonize data from different process sensors and/or tools that may be different, even for the same measured or imaged target. As another example (among many other possible examples), the autoencoder model disclosed herein may be configured to use wafer level priors and/or other information for tilt inference (and/or estimation, prediction, etc.).

One issue is etcher induced tilt resulting from an electrical field bend with regard to a perpendicular wafer direction. In some cases example, areas of maximum absolute tilt occur at or near the edges of wafer. Often, a fully unsupervised principal component analysis (PCA) approach is used for tilt inference (e.g., estimating or predicting the tilt at the edges of wafer). Raw pupil measurements are projected on a number of linear basis elements and one of them is manually chosen as representing a tilt signal based on expected tilt behavior. The coefficients resulting from the projection of the signal onto the chosen basis element are then fitted to an exponential model (e.g., exponential in the radial coordinate - in polar coordinates) to extract the signal component that is expected to be associated with tilt and to reject other possible components. Sometimes, full profile metrology relying on inverse problems (like CD reconstruction) can also be used for tilt inference. With this approach, a physical model is constructed and a parametrized stack signal is estimated using electromagnetic solvers. An optimization problem is solved to find the parametrization that ensures the best fit, thus producing tilt estimates.

Advantageously, the present autoencoder model can be configured such that wafer priors are used to ensure an informed decomposition is performed, instead of, in conjunction with, or in addition to, the uninformed approach used by a PCA based method. The modular autoencoder model can be configured such that it encodes the behavior of plasma in an etch chamber, for example, which induces a (modeled) radial behavior across the wafer. This is due to the bending of the electrical fields at the wafer edge and/or other factors. Such a radial effect projects onto stack features with a behavior dependent on the particular structure. For example, for an infinite grating, a sinusoidal variation with regard to the electrical field bend direction is expected, based on being perpendicular to the wafer, and based on grating orientation).

This can be interpreted as a projection onto a normal vector of the grating (this is the normal vector ("grating tilt amount")); maximal if orthogonal to the grating, minimal if parallel with the grating.

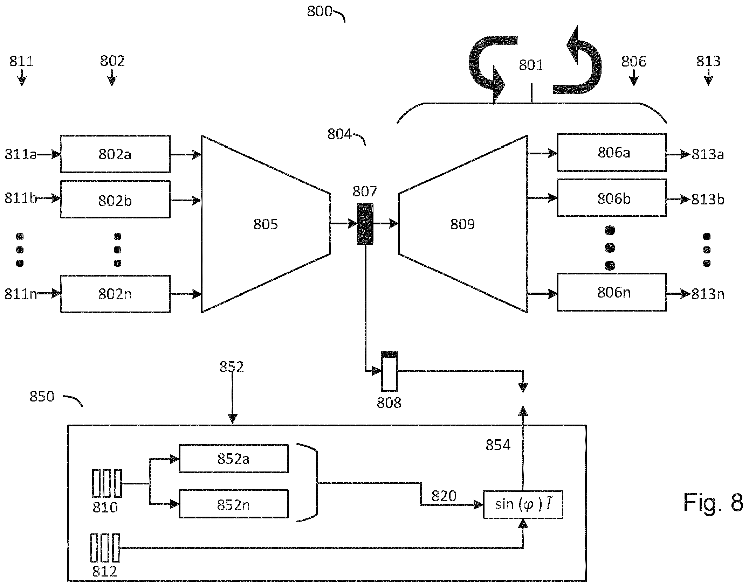

Figure 8 illustrates a schematic view of imposing 801 priors (via model 850) onto modular autoencoder model 800. More specifically, Figure 8 illustrates a schematic view of an interconnection structure for generating labels, in order to impose priors onto modular autoencoder model 800. Priors may be and/or include, for example, known, target, and/or otherwise predetermined values for specific wafer and/or patterning process variables. Imposing priors may include ensuring that the model behaves according to certain rules and/or expectations (e.g., based on prior knowledge and/or physical understanding). This sort of knowledge can usually not be learned from the data, so imposing priors may effectively add additional knowledge to the model.

Note that in Figure 8, model 808 is a given example embodiment of a prediction model 608, 708 (described above). Generically, model 808 comprises a block that connects the latent representation 807 to an output such as tilt in this example (output of model 808 as it is shown in Figure 8, but model 808 can be any generic prediction model). The output is constrained to belong to a class of signals that can be encoded by the priors. Note that the output of model 850 can only belong to the class of allowed signals while the output of 808 is free at this stage.

During training, the present systems and methods are configured to ensure the output of model 808 belongs to the appropriate class by training the output of model 808 to approximate the output of model 850. In this situation, model 850 can be trained to model any admissible signal in a class of possible signals. By ensuring the that the output of model 808 approximates the output of model 850, the present systems and methods ensure that the output from model 808 belongs to a class of signals of interest, while still allowing the information (that is provided to 850) to be used to decide the exact information encoded. This is possible since the output of model 850 can also be changed to model specific data, as long as this change is within the class of possible signals.

In some embodiments, modular autoencoder model 850 comprises one or more auxiliary models 852 (including models 852a ... 852n, each receiving a respective input 811a...811n of input data 811) configured to generate labels 854 for at least some of the low dimensional data in latent space 807. Labels 854 are configured to be used by prediction model 806 for estimations (e.g., predictions, inferences, etc.) of parameters 815 (e.g., such as tilt and/or other parameters). In some embodiments, labels 854 are configured to be used by modular autoencoder model 850 to impose a behavior (e.g., a behavior based on one or more independent variables) onto latent space 807 and/or outputs (e.g., estimations of parameters 815) of prediction model 808. The behavior is associated with a class of possible signals (e.g., tilt signals in this example, but any number of other possible signals are contemplated). If the prediction model is a simple mask as depicted in Figure 8 by 806, then parts of the latent space may be sub-selected and behavior may be imposed directly on the latent space. If a different model is used for the prediction model (e.g., a different model 808), the imposed behavior is added to the output of the prediction model (e.g., the different model 808), with the link to the latent space being less straightforward, as it goes backwards though the prediction model.

In some embodiments, the one or more auxiliary models 852 comprise one or more wafer models. The wafer models represent trainable models that impose the desired behavior onto latent space 807. This facilitates incorporation of physical knowledge about the etch process (in this example) and its interaction with a stack, during the training of one or more models of modular autoencoder model 850 (e.g., 802 (e.g., 802a-802n), 804, 805, 809, 806 (e.g., 806a-806n), 808, and/or 852). As described herein, these models can be neural networks, graph models, and/or other models that are constrained to model expected physical behavior (radial and sinusoidal tilt behavior in this example).

In some embodiments, the one or more wafer models (e.g., auxiliary models 852) may be configured to separate the pattern tilt from other asymmetries in stack and/or pattern features. In this example, the one or more wafer models are associated with pattern tilt, and the generated labels 854 are coupled to dimensional data in latent space 807 predefined to correspond to tilt, such that an informed decomposition based on wafer priors is performed by modular autoencoder model 850.

In some embodiments, input to the one or more wafer models (e.g., one or more auxiliary models 852) comprises data associated with a wafer pattern shape and/or wafer coordinates configured to be used to generate, encode, and/or constrain a class of signals (e.g., tilt signals in this example). Input to the one or more wafer models (e.g., auxiliary models 852) may comprise a wafer radius 810 (r) and/or (grating to wafer) angle comprising a location in polar coordinates associated with a pattern on a wafer, and/or other information. A second angle 812 ($\phi$) associated with the pattern on the wafer may also be used, along with a wafer identification, and/or other information. This angle is composed of both the polar coordinate angle and a constant phase associated with the orientation of the pattern on the wafer.

One or more appropriate auxiliary models may be selected (e.g., by a processor) 820 and used based on the input, such that labels 854 are matched with latent parameters across a wafer. In this example, a sine function is used because sine like behavior is expected. The tilt prior model has, in this example two inputs, the radius r and the angle phi. Note that this angle (in this example) is the sum of a constant angle determined by the grating alignment with the wafer and the angle related to the position on the wafer. The present model may be thought of as a model for the radial behavior, that produces the maximum tilt value $\tilde{l}$ (i.e. 820) for the case when the tilt of the plasma is fully orthogonal to the grating orientation in the XY-plane of the wafer. This value represents the radial component of the tilt prior. This component can be associated with the stack tilt depending on the plasma alignment with the grating (via the $sin(\phi)\tilde{I}$), since this alignment changes depending on the location on the wafer. After the model for the tilt is constructed, it can be coupled with the autoencoder (at 854).

The equation shown in Figure 8, sin ($\phi$) $I$, starting with the choice of sin projection, arises from the model for the etch induced tilt, for example. The alignment of the ions from the etch plasma with regards to the grating impacts the tilt of the grating, and can be modeled by sin ($\phi$) $I$, given an appropriate definition of $\phi$. The tilt, due to this projection, becomes 0 for example, when sin ($\phi$) = 0. In this situation, the plasma is still bending, it just does not result in grating tilt. These example inputs for tilt inference are not intended to be limiting. Other inputs may exist. For example, another tilt inducing factor can be wafer stress. In some embodiments, pattern feature density can be used to inspire a location based parametric wafer map model for tilt. The same type of constructs apply, with a different resulting auxiliary model, however. Other possible example behavior that can be enforced is related to a position on the wafer where tilt is occurring, namely at the wafer edge. An auxiliary model 852n can be configured (e.g., trained) to ensure small to zero values for the tilt signal in the interior of the wafer. Knowledge of etch chamber usage can serve as another type of example information that can be linked to the tilt behavior and/or magnitude (and can be trained into an auxiliary model 852n). With this information, an age (e.g., RF hours) or etcher setting (e.g., ring height, DC voltage, etc.) that control an electrical field can be correlated with a monotonical variation in the induced etch tilt, for example.

It should be noted that the description of Figure 8 provided above is not intended to be limiting. For example, different inputs for different applications exist. As described above, tilt related inputs may be associated with etch chamber usage, grating orientation, radial variation, circumferential (sinusoidal) variation, pattern feature density, and/or other stack information. However, inputs (or priors) (for tilt and/or any other application) may be generally thought of as any data that can be used to infer, estimate, predict, or otherwise determine a shape, geometrical information, and/or other information (e.g., any information that is to be extracted) associated with one or more parameters 815 of interest. Examples of other types of input to the one or more auxiliary models 852 include pupil data, data related to slit shape, etc..

As another example, more or less auxiliary models 852 than those described above may be included in modular autoencoder model 850, and/or auxiliary models 852 be arranged differently than shown in Figure 8. For example, one or more auxiliary models 852 may be embedded into one or more other models (e.g., encoder portion 805) in modular autoencoder model 850. As a third example, prediction model 808 may be formed by more than one individual model. In some embodiments, prediction model 808 comprises one or more prediction models, and the one or more prediction models are configured to estimate one or more parameters 815 based on labels 854 and/or one or more different outputs from the one or more auxiliary models 852. As a fourth example, in some embodiments, the one or more auxiliary models 852 are configured to be nested with one or more other auxiliary models 852 and/or one or more other models (e.g., 802, 804, 806, 808) of modular autoencoder model 850.

It should be noted that pupils, for example, can be used as input to the auxiliary model(s), which might originate from some special/dedicated targets and/or other sources.

In some embodiments, the one or more auxiliary models 852 are configured to be trained, using a cost function, to minimize a difference between the generated labels 854 and outputs (e.g., parameters 815) of one or more prediction models 808. The one or more prediction models 808 are configured to select appropriate latent variables (e.g., depending on parameters 815 of interest). The one or more auxiliary models 852 are configured to be trained simultaneously with the one or more input models 852, the common model 804, the one or more output models 806; and/or the prediction model 808.

A typical product stack of interest for, for example, in-device-metrology (IDM) techniques typically comprises multiple geometric parameters, out of which a subset are parameters of interest for metrology and control. Typically, the measured signal comprises information, in various degrees of strength/sensitivity, related to all geometric parameters. Because only a portion of these parameters are of interest, the signal contribution for the remainder should be accounted for and decoupled. In practice all parameters other than the one or more parameters of interest act as nuisance parameters which hinder the estimation of the parameter(s) of interest.

By way of a specific example, the removal of the signal contribution of nuisance parameters is important for both self-reference offset inference via current linear offset inference techniques as well as for self-reference offset inference and/or tilt inference using autoencoder models. For example, a present self-reference linear offset inference scheme comprises computing several nuisance wafer maps (spatial distributions of a parameter of interest) by appropriately decomposing the signal into signal modes that are constant per self-reference target cluster, using models correlated with the target reticle biases. As has been described, the stack parametrization may be divided into symmetric and asymmetric parameters, depending on the geometrical symmetries present in the unit cell of the structure. With autoencoder models, all parameters influencing the signal are modeled. Thus, the task of parameter (nuisance) selection becomes the task of deciding how to divide the energy of the signal between the parameters of interest and the nuisance parameters.

The (e.g., asymmetric) nuisance selection for the linear offset inference involves several manual inspection steps to identify the correct number of parameters to consider. This task remains very error prone and fully manual.

Furthermore, due to the simplified nature of the linear model used, the accuracy of such a decomposition remains good only within the linear regime of the parameter/signal mapping; this cannot be controlled, especially for the nuisance signals.

More complete modeling techniques using machine learning models to define a latent representation, e.g., using autoencoder models as has been described above and illustrated in Figures 5 to 8, require a predefined choice regarding the number of nuisance (extra) parameters. In such models, the allowed size of the parameterization c is fundamental to the ability of the model to capture all the signal information. However, the energy split between the parameters remains arbitrary, and if the number of chosen parameters is larger than necessary there will be degeneracy in the choice of the signal division. A reason for this degeneracy may also be due to correlation between parameters or re-parameterizations of the stack. Using a tilt inference example, this can lead to naive solutions such as predicting zero tilt, such that the tilt signal energy is instead modeled with the other parameters. For self-reference offset inference, this can result in an incorrect signal split leading to an incorrect choice for the self-reference target cluster offsets. At present, a manual inspection or comparison with third party data is required to determine the appropriate number of parameters. Even if the appropriate number of nuisance/extra asymmetric parameters is determined, a significant variability in results typically remains.

As has been described, physics inspired priors may be imposed; however these only guide the solutions, and the problem may remain partially ill-conditioned. As such, even when using such priors, naive solutions and poor energy split decisions may still be obtained leading to a significant solution variation between training instances.

As such, a method is proposed for imposing consistent ordering or ranking of latent elements within a latent representation (e.g., as obtained using an autoencoder architecture or otherwise) based on the contribution (e.g., a quantification of the contribution) of each latent element to signal approximation quality. Such a method may find and order subsets of the latent elements so as to maximize the signal energy modeled.

Therefore, disclosed herein is a method for ordering and/or selection of latent elements for modeling low dimensional data within a latent space representation, said low dimensional data being a reduced dimensionality representation of input data as determined by a first model component of a model. The method comprises the steps of: obtaining said input data; training said model and selecting one of said latent element selections based on said training. The training comprises: reducing a dimensionality of the input data to generate said low dimensional data in said latent space representation, said latent space representation comprising a plurality of latent elements; respectively training a second model component of said model for each of one or more latent element selections, each of said latent element selections comprising one or more of said plurality of latent elements; and optimizing an approximation of the input data as output by said second model component for each said latent element selection, thereby ranking at least one of said plurality of latent elements in the latent space representation based on a contribution of each latent element to the input data.

It is proposed to order the latent variables within the latent representation by importance/contribution to the measured signal. Such a method may comprise constructing models with latent variables $c_1,...c_n$ (where $n$ is the total number of latent variables) ordered based on their contribution in terms of the accuracy of the signal approximation (e.g., pupils measured by an optical metrology tool) by the (e.g., autoencoder) model using the ordered latent representation. In such a model, the most important signal content may be modeled by the first latent element $c_1$ (i.e., the parameter $c_1$ explains the maximal energy of the signal that can be modeled with only one parameter). The other elements will model the remaining signal content, again ordered, such that by increasing the number of elements in $c$, up to a point, an increasingly better signal model is obtained. When a certain number $k$ of latent elements or variables have been included, the model accuracy stops improving such that these first $k$ latent elements, $c_1,...,c_k$ model close to all the signal content. Such a method may comprise maximizing the approximation accuracy achievable by including all first $k$ latent elements, $c_1...,c_k$ with $k \le n$ and for any $k$. Such an idea extends the concept of (linear) low-rank approximation to non-linear autoencoder models.

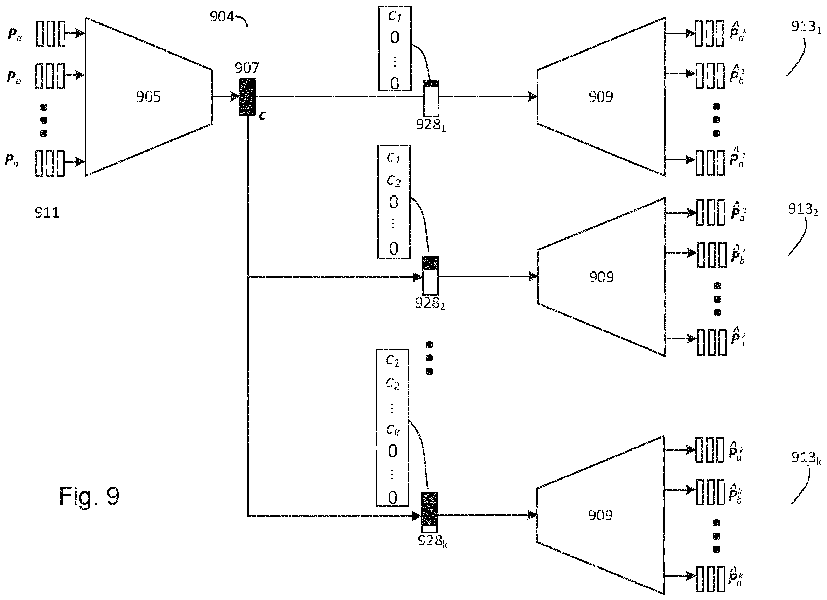

Figure 9 is a schematic drawing of an autoencoder architecture according to such an embodiment. The input arrangement (input data 911; e.g., pupils $P_1$, $P_2$, ..., $P_n$) and encoder portion 905 of the autoencoder model may be essentially similar to the autoencoder architectures of any of Figures 6 to 8 (and therefore may optionally comprise a modular architecture with input models, not shown in this Figure). However, in this embodiment, a decoder portion 909 is trained, based on a respective latent parameterization, latent element selection or latent masking $928_1$, $928_2$, $928_k$ of the latent representation 907. For each latent selection $928_1$, $928_2$, $928_k$, the decoder portion 909 outputs respective output data $913_1$ (e.g., approximated pupils $\widehat{P}_a^1, \widehat{P}_b^1, ..., \widehat{P}_n^1$ ), $913_2$ (e.g., approximated pupils $\widehat{P}_a^2, \widehat{P}_b^2, ..., \widehat{P}_n^2$ ) ... $913_k$ (e.g., approximated pupils $\widehat{P}_a^k, \widehat{P}_b^k, ..., \widehat{P}_n^k$ ).

Such an architecture allows monolithic training of the encoder 905 and decoder 909 while ordering the latent parameters in terms of accuracy of the signal approximation (e.g., by comparing output data $913_1$, $913_2$, ..., $913_k$ to the

input data 911. For example, properties may be encoded during the training of autoencoder models with the goal of building increasingly accurate approximations $\hat{P}_i$ of the pupils $P_i$ using appropriate selections of latent variables. For $c$ = $f(P_1, P_2, ..., P_n)$, the $k$-order approximation imposed by the decoder 909 may be described as a function of the output data: $g(c_k) \rightarrow [\hat{P}_1, \hat{P}_2,..., \hat{P}_n]$.

The constructed latent representation $c_k$ may comprise the same elements as the first $k$ positions of full latent representation $c$. In an embodiment, the remaining $k + 1, ...$ elements may be set as 0 for each latent representation $c_k$ (i.e., a first latent representation may comprise a single latent variable $c_1$ and zeroes for the remaining elements). Alternatively, the remaining elements may be set to another fixed value (e.g., for some parameters of interest it may be better to set these elements to a value other than zero, e.g., for symmetric parameters). As an alternative, these elements may be variable across wafers/targets; e.g., the value of these elements may be dependent on the input data.

As such, each parameter selection may comprise a different truncation (i.e., with all elements zeroed beyond the point of truncation) of the latent representation. Each of these truncations may be used in training the decoder, while optimizing an approximation of the input data as output by the encoder for each said latent element selection. In this manner, the parameters will be ranked in decreasing order of importance after training.

Generally speaking, the optimization may be such that the model training comprises minimizing the approximation error $e_k$:

$$e_k = \sum_i \left\| P_i - [\widehat{P}_i]_k \right\|$$

for all order approximations $k$. In this way, the first element of the latent should model the most important part of the signal, with further elements modeling the remainder with decreasing contributions in terms of signal power. The approximation error decreases with the increase of the approximation order $k$, $e_1 > e_2 > ... > e_k$.

By way of more specific examples, for overlay self-reference target offset inference and using conventional techniques, a cost function to be minimized may be stated as:

$$\text{minimize} \sum_{i=1}^{n} \left\| P_i - \widehat{P}_i \right\|_2^2 + \| o + \delta - \widehat{o} \| + g(\cdot)$$

where o describes the programmed biases, $\hat{o}$ is the model estimated biases, $\delta$ is the unknown process overlay shift (applicable to all targets of reference target cluster) and $g(\cdot)$ are optional priors/regularization terms. This is an ill-conditioned problem.

Using the proposed method, the cost function may be defined as:

$$\text{minimize} \sum_{i=1}^{n} \frac{1}{M} \sum_{k=1}^{M} \left\| P_i - g\left( \begin{bmatrix} I_k & 0 \\ 0 & 0_{M-k} \end{bmatrix} c \right) \right\|^2 + \| o + \delta - \widehat{o} \| + g(\cdot)$$

where once again priors/regularization terms $g(\cdot)$ are optional. $I_k$ is a diagonal identity matrix of size k × k and may comprise ones on the diagonal for the first k positions. This cost function applies a mask $\begin{bmatrix} I_k & 0 \\ 0 & 0_{M-k} \end{bmatrix}$ to the full latent representation. In such an example, the minimization may cause the overlay parameter to be the most significant parameter in the latent representation and associated with the first position.

Essentially the same approach may be taken for other parameters of interest. For example, the overlay term $\| o + \delta - \hat{o} \|$ may be replaced with a (etch) tilt term $\| t - \hat{t} \|$ where $t$ is the unknown tilt (parameter of interest) and $\hat{t}$ is the model estimated tilt. These are only a couple of examples, and the skilled person will recognize that the model training and latent representation optimization may be performed for many other parameters of interest derivable from measurement signals such as measurement pupils.

During training, the method can be applied for any sequence of masks to select elements of the latent. The example $\begin{bmatrix} I_k & 0 \\ 0 & 0_{M-k} \end{bmatrix}$ described above is one possible option which applies a natural order for the signal energy; however a different mask/ordering may be more appropriate for other applications.

Different groups of latent elements which are already separated in latent space (e.g., by another regularization term in the objective) may be treated separately. For example, in an embodiment, the ordering may be applied on only the asymmetric parameters (or only the symmetric parameters). As such, the symmetric latent parameters and asymmetric latent parameters may be separately treated. For example, if the parameter of interest is known to correlate with the asymmetric signal and therefore asymmetric latent parameters (such as overlay), then it may be that only these parameters are included in latent representation $c_k$, with all symmetric latent parameters zeroed (i.e., assumed to be nuisance parameters prior to training). The reverse can be done if the parameter of interest is known to correlate only with symmetric parameters.

Each latent element selection or mask may be determined *a priori*, such that the model is trained for a fixed choice of latent sampling options. In this way, multiple such choices may be tested by training multiple models and deciding which selection is preferred.

Once trained, the optimized (ordered) latent representation $c_k$ and corresponding (auto)encoder model can be used to infer parameters of interest (e.g., the parameter(s) of interest for which the optimized latent representation was optimized) from measurement data (measurement signals or pupils). As such, the prediction model may comprise the optimized mask for the parameter of interest. A more involved prediction model may also be used, however.

For parameter of interest inference, data may be passed via the encoder and observed in the optimized/masked latent (an additional prediction model may be used as described), or an associated inverse problem may be solved as an optimization task (e.g., to find the latent that, if passed via the decoder, results in a predicted signal that matches the measured data).

The proposed approach improves autoencoder modeling by promoting consistent behavior between different instances of the model creation/training, because it imposes a strict ordering in the latent representation. It removes the ability of the model to reparametrize the signal when the choice for the maximum number of latent variables is large, which again ensures consistency across models. The accuracy of tilt and offset inference models may be improved by requiring the model to account for all of the signal associated with the overlay or tilt in a single latent parameter. Without this prior, the latent parametrization can be overcomplete, such that the signal associated with the parameter of interest is in fact modeled by multiple latent elements. Furthermore, such an approach adds capability for the models to learn a minimal latent representation, should the configured latent representation have more elements than needed. In such situation, the elements that are not needed are associated with arbitrarily close to zero signal energy. This allows the modeling of the signal with the (smallest) appropriate number of latent elements. As such, this also simplifies the selection of the number of elements in the full latent representation, as this initial selection can now be larger than necessary for the parameter of interest inference.

While the concepts described above have used examples where the parameter of interest is overlay (and IDM overlay/offset inference in particular) and/or etch tilt, it should be understood that these are only examples and the concepts are equally applicable to other parameters of interest, such as layer thickness, grating imbalance, edge placement error, critical dimension, any one or more non-overlay structure asymmetry (e.g., side wall angle differences or bottom grating asymmetry)

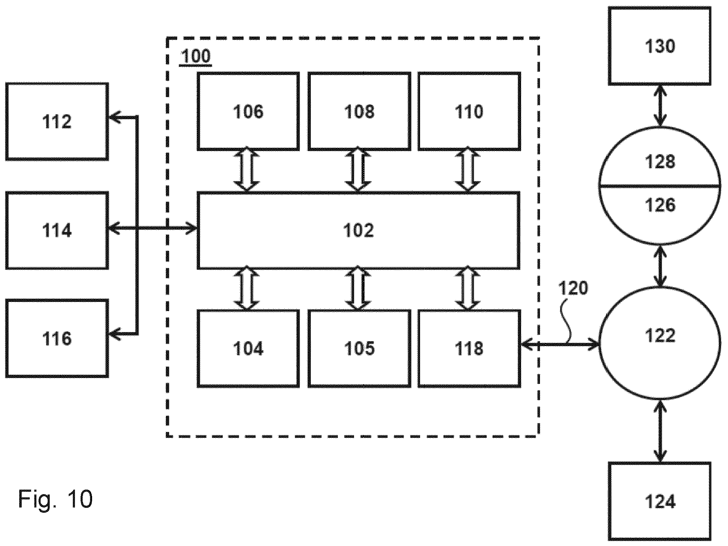

Figure 10 is a block diagram that illustrates a computer system 100 that can perform and/or assist in implementing the methods, flows, systems, or the apparatus disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may

19

also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer-readable medium" or "machine-readable" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 may also include a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are exemplary forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide all or part of a method described herein, for example. The received code may be executed by processor 104 as it is received, and/or stored in storage device 110, or other non-volatile storage for later execution. In this manner, computer system 100 may obtain application code in the form of a carrier wave.

Further embodiments are disclosed in the subsequent list of numbered clauses:

1. A method for ordering and/or selection of latent elements for modeling low dimensional data within a latent space representation, said low dimensional data being a reduced dimensionality representation of input data as determined by a first model component of a model; the method comprising the steps of:

obtaining said input data;
training said model, said training comprising:

reducing a dimensionality of the input data to generate said low dimensional data in said latent space representation, said latent space representation comprising a plurality of latent elements;
respectively training a second model component of said model for each of one or more latent element selections, each of said latent element selections comprising one or more of said plurality of latent elements; and

optimizing an approximation of the input data as output by said second model component for each said latent element selection, thereby ranking at least one of said plurality of latent elements in the latent space representation based on a contribution of each latent element to the input data; and selecting one of said latent element selections based on said training.

2. A method as defined in claim 1, wherein said optimizing step ranks one or more of the latent elements according to their contribution in terms of the accuracy of the signal approximation by said second model component.

3. A method as defined in claim 1 or 2, wherein a first latent element within said ranking explains the maximal energy of the input data that can be modeled with only one parameter.

4. A method as defined in any preceding claim, wherein said selecting step comprises selecting one of said latent element selections such that said signal energy of said input data is maximized by said low dimensional data when modeled according to the selected latent element selection.

5. A method as defined in any preceding claim, wherein said selecting step comprises selecting the latent element selection which uses the fewest latent elements to maximize the signal energy of said input data.

6. A method as defined in any preceding claim, wherein said training step comprises comparing the output of the second model component to the input data for each latent element selection.

7. A method as defined in any preceding claim, wherein said training step comprises minimizing the difference between the output of the second model component and the input data for each latent element selection.

8. A method as defined in any preceding claim, wherein each latent element selection is defined by an application of a mask of the form $\begin{bmatrix} I_k & 0 \\ 0 & 0_{M-k} \end{bmatrix}$ to the latent space representation, wherein $I_k$ is a diagonal identity matrix of size $k \times k$ comprising ones on the diagonal for the first $k$ positions, where $k$ is a latent element index from 1 to $M$, wherein $M$ is less than or equal to the total number of said plurality of latent elements.

9. A method as defined in any preceding claim, wherein said training and selection steps are performed to optimize the model for inferring one or more parameters of interest using said latent element selection.

10. A method as defined in claim 9, wherein said one or more parameters of interest comprise one or more of: overlay, etch tilt, layer thickness, grating imbalance, edge placement error, critical dimension, any one or more non-overlay structure asymmetry.

11. A method as defined in any preceding claim, wherein each of said latent element selections comprises the highest ranked latent elements, the number of said highest ranked latent elements comprised within each latent element selection increasing consecutively over said latent element selections.

12. A method as defined in any preceding claim, wherein all other latent elements than those sampled in each latent element selection is set to a fixed value.

13. A method as defined in any preceding claim, wherein all other latent elements than those sampled in each latent element selection is set to a value dependent on the input data.

14. A method as defined in any preceding claim, wherein said model is an autoencoder model, said first model component comprising an encoding component and the second model component comprising a decoding component.

15. A method as defined in claim 14, wherein said autoencoder model comprises a modular autoencoder model, further comprising one or both of:

one or more input models configured to process said input data to an intermediate level of dimensionality suitable for combining said input data, said intermediate level of dimensionality being intermediate to that of said input data and said low dimensional data; and
one or more output models configured to use output data from said second model component to generate different output data, having the same or increased dimensionality compared to the output data from said second model component.

16. A method as defined in any preceding claim, wherein, during said training step, different groups of said latent elements are treated separately.

17. A method as defined in claim 16, wherein said different groups are separated in said latent representation by regularization.

18. A method as defined in claim 16 or 17, wherein said separate groups comprise a first group comprising symmetric latent elements of said latent elements and a second group comprising asymmetric latent elements of said latent elements.

19. A method as defined in any preceding claim, comprising using the resultant trained model and selected latent element selection to infer one or more values for one or more parameters of interest based on input data.

20. A method as defined in any preceding claim, wherein said input data comprises or is derived from one or more pupil images, each said pupil image comprising an angularly resolved distribution of radiation scattered from a target, each said angularly resolved distribution comprising one or more of an angularly resolved intensity distribution, an angularly resolved amplitude distribution and an angularly resolved phase distribution.

21. A computer program comprising program instructions operable to perform the method of any of claims 1 to 20, when run on a suitable apparatus.

22. A non-transient computer program carrier comprising the computer program of claim 21.

23. A processing system comprising:

the non-transient computer program carrier of claim 22; and
a processor operable to run said program instructions.

24. A metrology apparatus configured to measure product structures formed on a substrate in a lithographic process, said metrology apparatus comprising the processing system of claim 23.

The concepts disclosed herein may simulate or mathematically model any generic imaging system for imaging sub wavelength features, and may be especially useful with emerging imaging technologies capable of producing increasingly shorter wavelengths. Emerging technologies already in use include EUV (extreme ultra violet), DUV lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range.

While the concepts disclosed herein may be used for imaging on a substrate such as a silicon wafer, it shall be understood that the disclosed concepts may be used with any type of lithographic imaging systems, e.g., those used for imaging on substrates other than silicon wafers, and/or metrology systems. In addition, the combination and subcombinations of disclosed elements may comprise separate embodiments. For example, predicting a complex electric field image and determining a metrology metric such as overlay may be performed by the same parameterized model and/or different parameterized models. These features may comprise separate embodiments, and/or these features may be used together in the same embodiment.

Although specific reference may be made in this text to embodiments of the invention in the context of a metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography. While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A method for ordering and/or selection of latent elements for modeling low dimensional data within a latent space representation, said low dimensional data being a reduced dimensionality representation of input data as determined by a first model component of a model; the method comprising the steps of:

obtaining said input data;
training said model, said training comprising:

reducing a dimensionality of the input data to generate said low dimensional data in said latent space representation, said latent space representation comprising a plurality of latent elements; respectively training a second model component of said model for each of one or more latent element selections, each of said latent element selections comprising one or more of said plurality of latent elements; and
optimizing an approximation of the input data as output by said second model component for each said latent element selection, thereby ranking at least one of said plurality of latent elements in the latent space representation based on a contribution of each latent element to the input data; and

selecting one of said latent element selections based on said training.

2.  A method as claimed in claim 1, wherein said optimizing step ranks one or more of the latent elements according to their contribution in terms of the accuracy of the signal approximation by said second model component.

3.  A method as claimed in claim 1 or 2, wherein a first latent element within said ranking explains the maximal energy of the input data that can be modeled with only one parameter.

4.  A method as claimed in any preceding claim, wherein said selecting step comprises selecting one of said latent element selections such that said signal energy of said input data is maximized by said low dimensional data when modeled according to the selected latent element selection.

5.  A method as claimed in any preceding claim, wherein said training step comprises comparing the output of the second model component to the input data for each latent element selection.

6.  A method as claimed in any preceding claim, wherein said training step comprises minimizing the difference between the output of the second model component and the input data for each latent element selection.

7.  A method as claimed in any preceding claim, wherein said training and selection steps are performed to optimize the model for inferring one or more parameters of interest using said latent element selection.

8.  A method as claimed in claim 7, wherein said one or more parameters of interest comprise one or more of: overlay, etch tilt, layer thickness, grating imbalance, edge placement error, critical dimension, any one or more non-overlay structure asymmetry.

9.  A method as claimed in any preceding claim, wherein each of said latent element selections comprises the highest ranked latent elements, the number of said highest ranked latent elements comprised within each latent element selection increasing consecutively over said latent element selections.

10. A method as claimed in any preceding claim, wherein said model is an autoencoder model, said first model component comprising an encoding component and the second model component comprising a decoding component, and wherein said autoencoder model comprises a modular autoencoder model, further comprising one or both of:

one or more input models configured to process said input data to an intermediate level of dimensionality suitable for combining said input data, said intermediate level of dimensionality being intermediate to that of said input data and said low dimensional data; and
one or more output models configured to use output data from said second model component to generate different output data, having the same or increased dimensionality compared to the output data from said second model component.

11. A method as claimed in any preceding claim, wherein, during said training step, different groups of said latent elements are treated separately.

12. A method as claimed in claim 11, wherein said separate groups comprise a first group comprising symmetric latent elements of said latent elements and a second group comprising asymmetric latent elements of said latent elements.

13. A method as claimed in any preceding claim, comprising using the resultant trained model and selected latent element selection to infer one or more values for one or more parameters of interest based on input data.

14. A method as claimed in any preceding claim, wherein said input data comprises or is derived from one or more pupil images, each said pupil image comprising an angularly resolved distribution of radiation scattered from a target, each said angularly resolved distribution comprising one or more of an angularly resolved intensity distribution, an angularly resolved amplitude distribution and an angularly resolved phase distribution.

15. A metrology apparatus configured to measure product structures formed on a substrate in a lithographic process, said metrology apparatus comprising a processing system operable to perform the method of any of claims 1 to 14.

Fig. 1

Fig. 2

LA

SC1

SC3

CL

-1   0   +1

SC2

MT

Fig. 3

40

44

SM1

Z

X

PU

42

I

46

Z

48

λ

X

Fig. 4

Fig. 5

Fig. 6

Fig. 7

Fig. 8

Fig. 9

Fig. 10

Europäisches
Patentamt

European
Patent Office

Office européen
des brevets

# EUROPEAN SEARCH REPORT

Application Number

EP 22 16 4893

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | "MODULAR AUTOENCODER MODEL FOR MANUFACTURING PROCESS PARAMETER ESTIMATION", RESEARCH DISCLOSURE, KENNETH MASON PUBLICATIONS, HAMPSHIRE, UK, GB , vol. 685, no. 71 1 May 2021 (2021-05-01), XP007149401, ISSN: 0374-4353 Retrieved from the Internet: URL:ftp://ftppddoc/RDData685_EPO.zip Pdf/685071.pdf * paragraph [0219] - paragraph [0220]; figures 1,7 * * paragraphs [0097], [0113], [0163] * * paragraph [0176] - paragraph [0179] * | 1-15 | INV. G06N3/04 G06N3/08 G03F7/20 |

TECHNICAL FIELDS
SEARCHED      (IPC)

G06N
G03F

The present search report has been drawn up for all claims

| Place of search | Date of completion of the search | Examiner |
|---|---|---|
| The Hague | 16 September 2022 | Falco, Gabriele |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B

- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1